# EUROPEAN PATENT APPLICATION

(11) **EP 1 638 136 A1**
(43) Date of publication of application: **22.03.2006**
(21) Application number: 04745765.0
(22) Date of filing: 10.06.2004
(51) Int. Cl.: H01L 21/205, H01L 29/04

(54) **SILICON EPITAXIAL WAFER MANUFACTURING METHOD AND SILICON EPITAXIAL WAFER**

(30) Priority: 17.06.2003 JP 2003172269
(71) Applicant: Shin-Etsu Handotai Co., Ltd, Tokyo 100-0005 (JP)
(72) Inventor: YOSHIDA, T., c/o SHIN-ETSU HANDOTAI CO., LTD, Annaka-shi, Gunma 379-0196 (JP); SHIMAZAKI, M., c/o SHIN-ETSU HANDOTAI CO., LTD, Annaka-shi, Gunma 379-0196 (JP)
(74) Representative: Harding, Richard Patrick
(86) International application number: PCT/JP2004/008135
(87) International publication number: WO 2004/114384

(57) **Abstract**

An angular range allowing overlapping, at a minimum angle of rotation, of a normal line vector α on the main plane MP of the substrate and a normal line vector β on the inner wall plane in the longitudinal direction of trench 11 filled with a fill-up epitaxial layer is defined as a transition plane normal line angular range θ, and a region composing the opening edge in the longitudinal direction of the trench is assumed as a transition plane region over which a normal line vector continuously changes within the transition plane normal line angular range θ. The Miller index (h₁k₁l₁) of the main plane MP of the substrate and the Miller index (h₂k₂l₂) of the inner wall plane WP in the longitudinal direction of the trench are then determined, so as to make a normal line vector on all {111} planes in the silicon single crystal substrate 2 fall outside the transition plane normal line angular range θ. This provides a method of fabricating a silicon epitaxial wafer, making it less likely to cause narrowing of trench opening due to excessive growth of the fill-up epitaxial layer, and consequently making it possible to effectively suppress residual voids in the fill-up epitaxial layer in the trench, even under a large aspect ratio of the trench.

## Description

### Field of the Invention

This invention relates to a method of fabricating a silicon epitaxial wafer, and an epitaxial wafer thus fabricated.

### Background Art

There is a known technique for forming, in a silicon epitaxial wafer having a silicon single crystal film epitaxially grown on a silicon single crystal substrate (also simply referred to as epitaxial wafer, hereinafter), an ion implanted layer containing an impurity by the ion implantation process into the silicon single crystal film thereof (also referred to as silicon epitaxial layer or simply as epitaxial layer, hereinafter), and of further forming another epitaxial layer to thereby leave the ion implanted layer as a buried layer. In some cases, depth-wise long impurity-added regions (referred to as vertical addition region hereinafter in this specification) must be formed in the epitaxial wafer, in the process of fabricating elements such as power MOSFET and vertical bipolar transistors. Planar MOSFET produces a current path mainly in the in-plane direction of the impurity-added region, whereas fabrication of a vertical addition region raises an advantage of allowing the current to conduct in the thick-wise direction of the region, and of reducing the ON resistance of the element.

A deep vertical addition region can be formed by a method, as described in Japanese Laid-Open Patent Publication "Tokkai" No. 2001-139399, repeating a step of growing an epitaxial layer and a step of ion implantation, but this raises a disadvantage of readily increasing the number of process steps and the cost. Japanese Laid-Open Patent Publication "Tokkai" Nos. 2002-196573 and 2002-141407 therefore discloses techniques for forming trenches (grooves) by etching on the main surface of the silicon single crystal substrate, and by growing a fill-up epitaxial layer so as to fill the trenches.

In order to fulfill recent demands on higher integration of silicon devices, there has been a need of forming the vertical addition region with a smaller area and a larger depth, and this needs the corresponding trenches to have a considerably large aspect ratio of the depth relative to the width of the opening. Japanese Laid-Open Patent Publication "Tokkai" No. 2001-196573 pointed out a problem in that the fill-up epitaxial layer would close the opening portion of the trenches as it grew on the inner wall plane of the trenches, and would be more likely to leave voids inside the trenches. As one specific method of solving the problem, there has been disclosed a method of once interrupting the growth of the fill-up epitaxial layer, introducing a fresh HCl gas so as to remove by etching an unnecessary portion of the epitaxial layer clogged at the opening, and restarting the growth of the fill-up epitaxial layer.

Japanese Laid-Open Patent Publication "Tokkai" No. 2001-196573, however, does not detail the root cause of the excessive growth of the fill-up epitaxial layer at the opening of the trenches. The idea of "it is enough to stop the growth and to etch the layer if the opening is about to be clogged" is no more than a symptomatic treatment, and does not give an essential solution. Of course, the process of repeating the epitaxial growth and etching is complicated and labor-consuming, and results in an increased cost.

It is therefore the subject of the present invention to provide a method of fabricating a silicon epitaxial wafer less likely to cause clogging at the opening portion of trenches due to excessive growth of the fill-up epitaxial layer, and capable of effectively suppressing residence of voids or the like in the fill-up epitaxial layer in the trenches; and also to provide a silicon epitaxial wafer capable of realizing a high-quality, and a fill-up epitaxial layer having only a less amount of residual voids or the like even under a large aspect ratio of the trenches.
Patent document 1: Japanese Laid-Open Patent Publication "Tokkai" No. 2001-139399;
Patent document 2: Japanese Laid-Open Patent Publication "Tokkai" No. 2001-196573;
Patent document 3: Japanese Laid-Open Patent Publication "Tokkai" No. 2004-141407;
Non-patent document 1: D. Kishimoto *et al*., the Journal of Crystal Growth, 240 (2002), 52;
Non-patent document 2: Ichiro Mizushima *et al*., Oyo Butsuri (The Japan Society of Applied Physics), 69 (2000), 1187; and
Non-patent document 3: H. Kuribayashi *et al*., AVS 49th International Symposium, SS-TuP12, Nov. 3-8 (2002).

### Disclosure of the Invention

This invention relates to a method of fabricating a silicon epitaxial wafer having a trench formed on the main plane of a silicon single crystal substrate, the inner space of the trench being filled with a fill-up epitaxial layer composed of a silicon single crystal, wherein the first aspect of which is characterized in:
under definition of an angular range allowing overlapping, at a minimum angle of rotation, of a normal line vector α on the main plane of the substrate and a normal line vector β on the inner wall plane in the longitudinal direction of the trench as a transition plane normal line angular range, and under assumption of a region composing the opening edge in the longitudinal direction of the trench as a transition plane region over which a normal line vector continuously changes within the transition plane normal line angular range, determining Miller index (h₁k₁l₁) of the main plane of the substrate and Miller index (h₂k₂l₂) of the inner wall plane in the longitudinal direction of the trench, so as to make a normal line vector on plane {111} fall outside the transition plane normal line angular range; and
obtaining a silicon single crystal substrate having the main plane expressed by Miller index (h₁k₁l₁), forming trench having the inner wall plane in the longitudinal direction expressed by Miller index (h₂k₂l₂) on the main plane of the substrate, and allowing the fill-up epitaxial layer to grow inside the trench.

A silicon epitaxial wafer of this invention has a trench formed on the main plane of the silicon single crystal substrate, the inner space of the trench being filled with a fill-up epitaxial layer composed of a silicon single crystal, and;
under definition of an angular range allowing overlapping, at a minimum angle of rotation, of a normal line vector α on the main plane of the substrate and a normal line vector β on the inner wall plane in the longitudinal direction of the trench as a transition plane normal line angular range, and under assumption of a region composing the opening edge in the longitudinal direction of the trench as a transition plane region over which a normal line vector continuously changes within the transition plane normal line angular range, has the Miller index (h₁k₁l₁) of the main plane of the substrate and the Miller index (h₂k₂l₂) of the inner wall plane in the longitudinal direction of the trench determined so as to make a normal line vector on plane {111} fall outside the transition plane normal line angular range.

It is to be understood that in the description below, the crystal plane index is expressed as (hkl) using the Miller index (symbol {hkl} is used for representatively expressing a plurality of crystallographically symmetric planes), and the crystal axis orientation is expressed as [hkl] (symbol <hkl> is used for representatively expressing a plurality of crystallographically symmetric axis orientation.) In the Miller index notation, a minus sign expressing a negative index is generally given above the index, but this patent specification adopts the notation of placing the minus sign before the index as a matter of convenience.

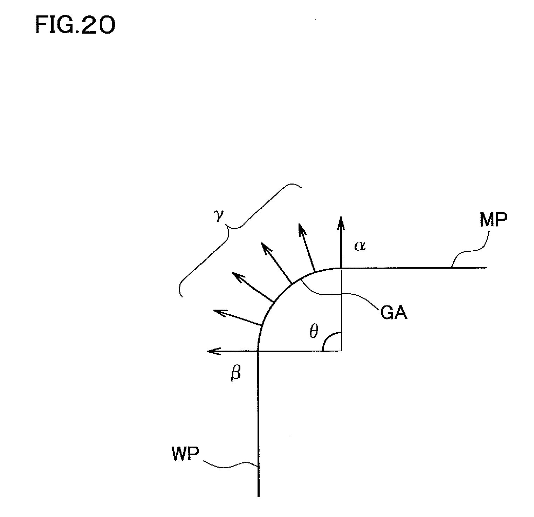

The normal line vector on the crystal plane appears on the surface of the silicon single crystal substrate is defined as having a directionality from the side having the entity of the crystal, including the main plane MP of the substrate and the inner wall plane WP of the trenches, resides thereon, towards the side having no crystal residing thereon. It is therefore made possible to idealize, as shown in FIG. 20, a region composing the opening edge of the trench in a longitudinal direction as a curved surface GA, in a transition plane normal line angular range θ allowing a normal line vector α on the main plane of the substrate to overlap a normal line vector β on the inner wall plane, over which a normal line γ vector continuously (and monotonously) changes from the normal line vector α side to the normal line vector β side (the curved surface can be approximated as a set of microplanes having normal line vectors γ having different directions). If precisely discussed, the surface geometry of the opening edge portion of the trench may not be said as having a planar index which changes in a crystallographically continuous manner, but in a technical sense, the geometric idealization as a curved surface (rounded surface, for example) allowing continuous change in the index, as shown in FIG. 20, will raise no problem in view of understanding the overall behavior of the growth of the epitaxial layer at the opening edge portion.

The present inventors found out that an essential factor, making the opening of the trench more likely to be clogged by the excessive growth of the fill-up epitaxial layer, resides in that the growth rate of the fill-up epitaxial layer largely depends on the orientation of the growth plane in a silicon single crystal, and is also readily affected by a relative relation of plane orientation between the in-trench wall plane and the main plane of the silicon single crystal substrate. More specifically, under assumption that the opening edge portion of the trench as a transition plane region allowing transition from the plane orientation of the main plane of the substrate to the plane orientation of the in-trench wall plane, and under conditions that the transition plane region contains a plane expressed by a specific index, more specifically plane {111}, it was found that the excessive growth portion of the fill-up epitaxial layer potentially causing clogging of the opening edge portion of the trench, becomes more likely to be formed.

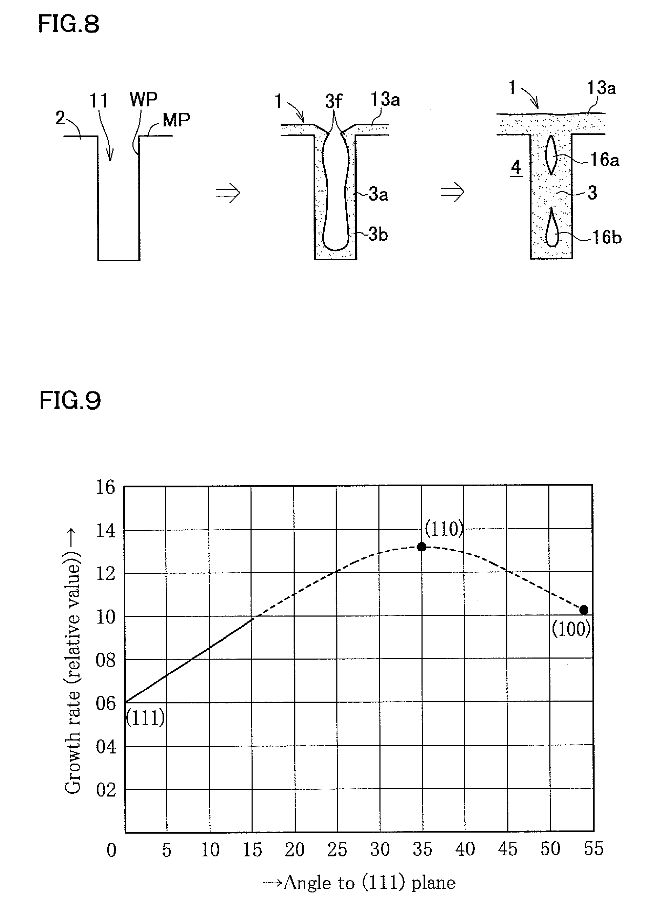

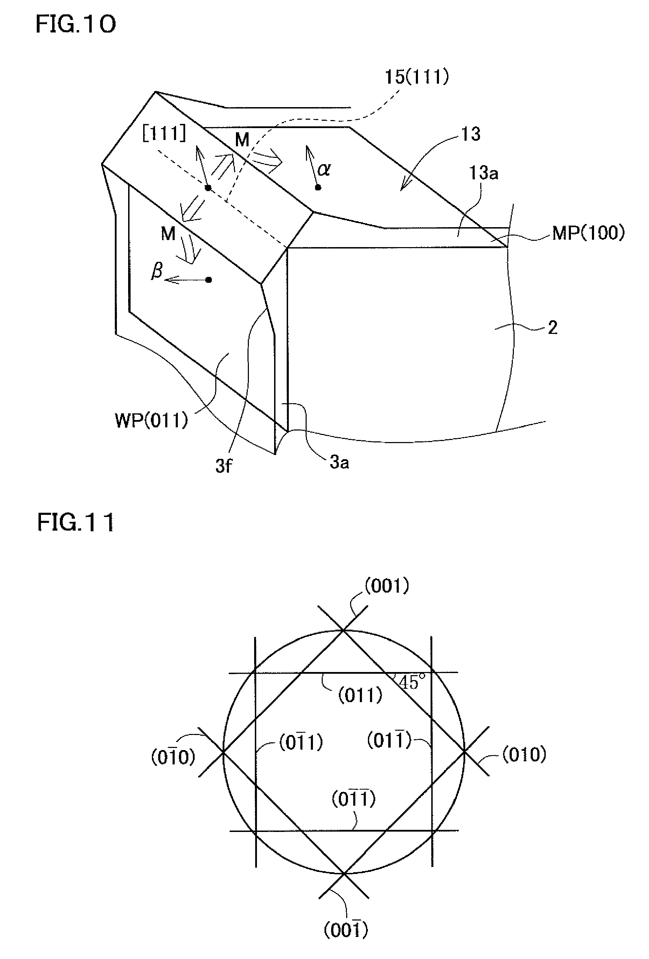

As shown in FIG. 9, in the epitaxial growth of silicon, the growth rate is minimum on plane {111}, and from the minimum value, the growth rate largely varies depending on an angular discrepancy from plane {111}. The growth rate becomes maximum on plane {110}. Discussing now on some major plane indices, the growth rate on plane {100} is smaller by 30% than that on plane {110}, and the value on plane {111} is minimized as being smaller by 50% or more than that on plane {110}. For an exemplary case as shown in FIG. 10 in which plane (111) (normal line of which is expressed by [111]) is contained in transition plane region 15 composing the opening edge of the trench, the growth rate of epitaxial layer 14 is minimized at the edge position giving normal line [111], but formation of an excessive growth portion 3f becomes more distinctive at the position more distant from the edge towards the main plane MP side of substrate 2 and towards the in-trench wall plane WP side, due to a sharp increase in the growth rate. Assuming now the normal line vector on the main plane MP of the substrate as α, and the normal line vector on the in-trench wall plane WP as β, it is understood that the angular range (transition plane normal line region) allowing the normal line vector α to overlap the normal line vector β at a minimum angle of rotation will contain normal line [111] on plane (111) giving a local minimum (and absolute minimum) growth rate.

Therefore in this invention, assuming a region composing the opening edge in the longitudinal direction of a trench as a transition plane region over which a normal line vector continuously changes within the transition plane normal line angular range, the Miller index (h₁k₁l₁) of the main plane of the substrate and the Miller index (h₂k₂l₂) of the in-trench wall plane are determined so as to make a normal line vector on plane {111} fall outside the transition plane normal line angular range. In other words, the {111} plane giving thereon a minimum growth rate is excluded from the transition plane region. This makes it possible to very effectively suppress the excessive growth of the fill-up epitaxial layer, and consequent narrowing of the trench opening, on the substrate main plane MP side and on the in-trench wall plane WP side bounded by the opening edge of the trench. As a consequence, a residue of voids or the like in the fill-up epitaxial layer in the trench become less likely to occur even under a large aspect ratio of the trench, making it possible to improve the production yield. Thus-obtained silicon epitaxial wafer is excellent in quality, having only a less amount of residual voids or the like in the fill-up epitaxial layer (corresponding to the additional vertical region).

Another possible factor can be as follows. That is, when plane {111} is contained in the opening edge of the trench, Si-containing adsorption species (typically Si-containing radical derived from a source gas molecule) tries to adsorb on the opening may fail to contribute to silicon deposition, because plane {111} allows thereon only a growth rate considerably smaller than those allowed by other planes composing the substrate main plane and in-trench wall plane, such as plane {100} and plane {110}, and becomes more likely to migrate, as indicated by arrow M in FIG. 10, so as to be effluent towards the substrate main plane side and towards the in-trench wall plane side. As a consequence, on both sides of edge {111}, the Si-containing adsorption species becomes more likely to proceed adsorption and the resultant Si deposition and growth, and to make the excessive growth more distinctive, because concentration of the Si-containing adsorption species becomes locally high towards the substrate main plane side or towards the in-trench wall plane side, as being affected by the migration, and also because the growth rate increases as the plane orientation becomes more distant from plane {111}. In other words, because edge {111}, allowing thereon only a small growth rate, is contained in the opening edge region, it is supposed that the difference in the growth rates between edge {111}, and the regions on both sides thereof induces the migration so as to supply the source material preferentially to both sides of edge {111}, thereby expanding the difference in the amount of growth between edge {111}, and the regions on both sides thereof, beyond estimation based on difference in the static growth rate corresponding to the plane orientation, and this may consequently make the formation of the excessive growth portion, causative of clogging of the trench openings, more distinctive. The above-described migration has been confirmed on a GaAs single crystal, having similarity in the facet formation behavior on plane {111} and plane {100}, typically as described in D. Kisimoto *et*. *al*., The Journal of Crystal Growth, 240 (2002) 52, so that a similar migration is most likely to occur also on the Si single crystal, according to Ichiro Mizushima *et*. *al*., Oyo Butsuri (The Japan society of Applied Physics), 69 (2000), 1187 and H. Kuribayashi *et al*., AVS 49th International Symposium, SS-TuP12, Nov. 3-8 (2002). In contrast, this invention can simultaneously suppress the migration by virtue of exclusion of plane {111} from the opening edge region, and thereby can effectively suppress the narrowing of the trench openings.

Summarizing the above discussion, when plane {111} allowing thereon a minimum growth rate which is contained at an intermediate angular position in the transition plane normal line angular range, the growth rate of silicon therefore changes in the direction of increasing as the point of observation shifts towards whichever the in-trench wall plane side or towards the substrate main plane side from the edge position composed of plane {111}, over the transition plane region, and this makes the narrowing of the trench openings more likely to occur due to the excessive growth portion. The nonconformity is therefore suppressed by excluding plane {111} from the transition plane region. In this case, a more preferable mode of embodiment is such as determining the Miller index (h₁k₁l₁) of the main plane of the substrate and the Miller index (h₂k₂I₂) of the inner wall plane in the longitudinal direction of the trench, so as to maximize the growth rate distribution of silicon in the transition plane region at an intermediate angular position between the main plane of the substrate and inner wall plane in the longitudinal direction of the trench. In other words, if the maximum value of the growth rate resides at the edge position in the transition plane region, then the growth rate of silicon changes in the decreasing direction as the point of observation shifts towards whichever the in-trench wall plane side or towards the substrate main plane side from the edge position composed of plane {111}, over the transition plane region. In addition, exclusion of the plane, allowing thereon only a small growth rate, from the opening edge makes the migration of the Si source material towards the in-trench wall plane side and towards the substrate main plane side less likely to occur. This makes it possible to largely suppress formation of the excessive growth portion, and to effectively prevent the narrowing of the trench openings.

In some cases, with the growth process of the fill-up epitaxial layer, the epitaxial layer also grows on the region of the substrate main plane other than the trenches, wherein the epitaxial layer can be removed by polishing if it is unnecessary. The polishing may remove portions forming by the opening edge of the trenches in the growth process of the epitaxial layer.

Substrate (100) is most widely used as the silicon single crystal substrate for fabricating the silicon epitaxial wafer, in view of readiness of pulling-up of single crystal, and with price advantages. The above-described Japanese Laid-Open Patent Publication "Tokkai" No. 2001-196573 dare adopt substrate (110), aiming at forming the trenches by anisotropic wet etching, wherein in order to obtain substrate (110), it is necessary to grow silicon single crystals around a principal axis [110] by the Czochralski method, floating zone method or the like. Single crystal [110] is, however, exceptionally very likely to convert into polycrystal due to occurrence of dislocation, and a problem resides in that it is almost impossible to prepare an exceptionally heavily-doped single crystal with a large production yield.

For the case where the Miller index (h₁ k₁l₁) of the main plane of the substrate is defined as (100) as described above, the trench is preferably configured as having the depth-wise direction thereof agreed with the thickness-wise direction of the substrate, and as having the Miller index (h₂k₂I₂) of the wall plane in the longitudinal direction (in-trench wall plane) defined so that the wall plane in the longitudinal direction crosses any one of four {110} planes, composing the crystal zone around axis [100], at an angle from 5° to 45°, both ends inclusive. It is to be understood that a plurality of crystal planes, having different plane indices but aligned in parallel with a single common crystal axis, are defined as "composing the crystal zone" with respect to the crystal axis, wherein the crystal axis is referred to as "crystal zone axis". Four {110} planes composing the crystal zone with respect to axis [100], there are four (011), (0-11), (0-1-1) and (01-1) planes (see FIG. 11).

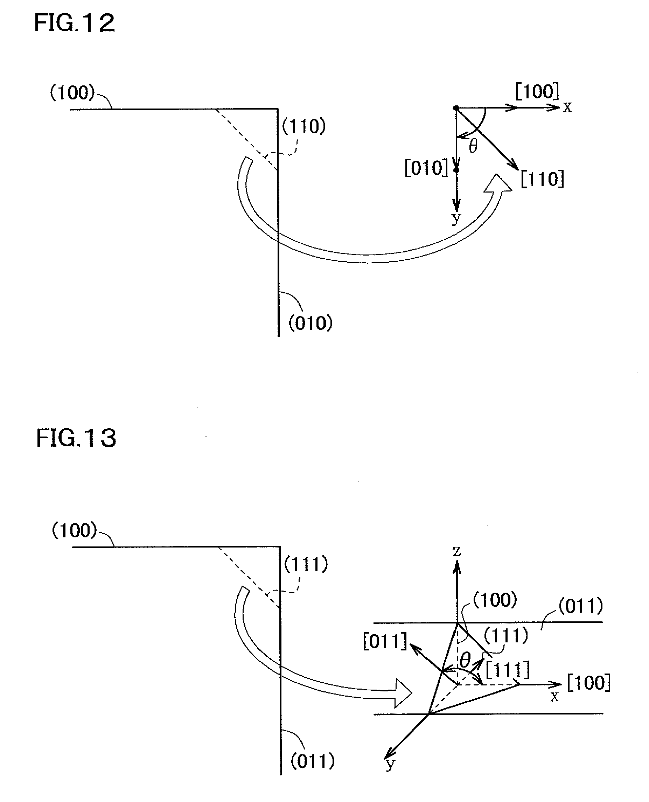

For the case, as shown on the left of FIG. 13, where the substrate main plane is given as (100) (where an off-angle margin of about 4° is allowable, wherein the substrate main plane in this case also considered as being the (100) plane in a broad sense), and the in-trench wall plane is given as (011), the transition plane normal line angular range θ specified by the normal line vectors (crystal axis orientation indices) [100] and [011] on both surfaces, shown on the right of FIG. 13, contains normal line vector [111] on plane (111). The opening edge portion of the trench where plane (100) and plane (011) cross to each other will have plane (111) appeared therein, as shown on the left of FIG. 13. That is, the opening edge portion can be understood as a transition plane region allowing continuous change within the transition plane normal line angular range θ.

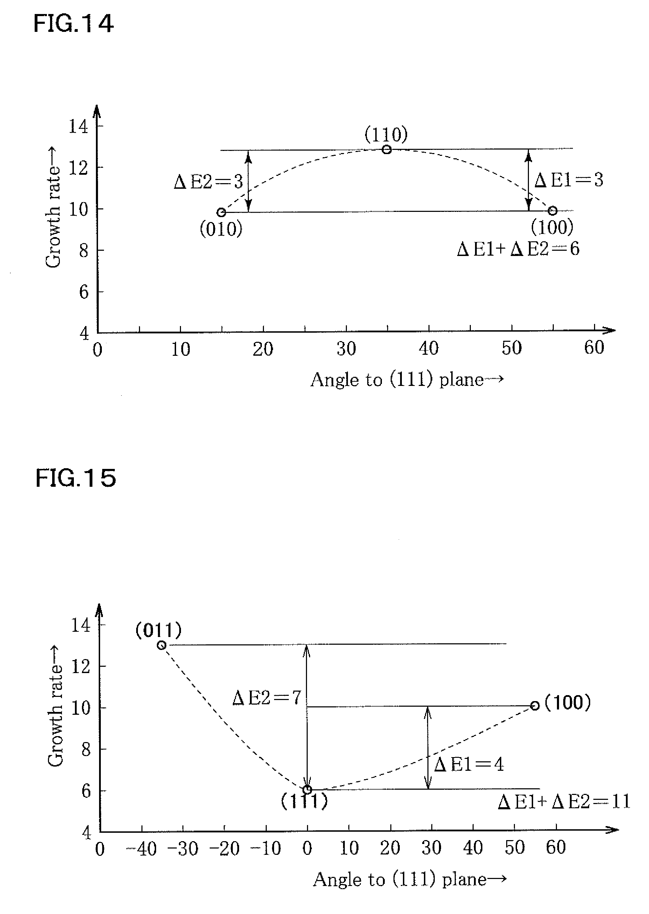

FIG. 15 shows how the growth rate of the epitaxial layer changes within the transition plane normal line angular range θ over which the plane orientation transits from (100) through (111) to (011). The growth rate herein is expressed by a relative value assuming the rate on plane (111) as 6. It is found from the drawing, that in-trench-wall plane (011) which falls on the originating point of the angular range θ shows the largest growth rate (13 on the relative basis) out of all planes, and on the contrary, plane (111) which appears midway on the angular range θ shows the smallest growth rate (6 on the relative basis) out of all planes. Difference ΔE1 in the growth rates between plane (111) composing the opening edge and substrate main plane (100) appears as 4 on the relative basis, and difference ΔE2 in the growth rates with respect to in-trench wall plane (011) appears as 7. A larger value of the sum ΔE1+ΔE2 of the differences of the growth rates tends to give a larger growth rate at around the opening edge portion, and ΔE1+ΔE2 in the above case appears as large as 11 on the relative basis. The difference △E2 in growth rates on the in-trench wall plane (011) side, which largely affects the narrowing of the opening, appears especially as large as 7. That is, as shown in FIG. 10, this composes a large factor of promoting formation of the excessive growth portion 3f at the trench opening.

It is, however, made possible to suppress the formation of the excessive growth portion, if the in-trench-wall plane crosses plane {110} at a predetermined angle, because the transition plane normal line angular range θ rotates in the direction departing from the <111> direction as expressed in the coordinate on the right of FIG. 13, so as to make plane {111}, allowing thereon the minimum growth rate, disappear from the transition plane region at the trench opening. Considering the symmetry of four {110} planes composing the crystal zone with respect to axis [100] as shown in FIG. 11, the angle of crossing between the in-trench wall plane and plane {110} may be 45° or smaller. In this case, the angle of crossing between the in-trench wall plane and plane {110} is preferably set to 5° or larger, because an extremely small angle results in inclusion of a higher-index plane having a planar index close to {111} in the transition plane region, and makes the effect non-distinctive. From the viewpoint of relative value of the growth rate shown in FIG. 9, it is preferable to adjust the sum ΔE1+ΔE2 of the differences of the growth rates, on the basis of the minimum value of the growth rate within the transition plane normal line angular range θ, to 8 or smaller on the relative value basis, and in particular to adjust the difference ΔE2 of the growth rates with respect to the in-trench wall plane to 5 or smaller.

It is still more preferable to determine the above-described angle of crossing, and consequently a plane index of the in-trench wall plane in the longitudinal direction, so as to maximize the growth rate distribution at an intermediate angular position between the substrate main plane side and the in-trench wall plane in the longitudinal direction, as described in the above. For example, the angle of crossing preferably coincides with any one of four {100} planes composing the crystal zone with respect to axis [100]. When the substrate main plane is given as (100) and the in-trench wall plane as (010) as shown in FIG. 12, plane {111} will not appear in the transition plane normal line angular range θ between two these planes. In this case, the transition plane normal line angular range θ includes the normal line on plane (110). FIG. 14 shows how the growth rate of the epitaxial layer varies over the transition plane normal line angular range θ over which the plane orientation transits from (100) through (111) to (011). It is seen that the growth rate is maximized (becomes largest) at the position of plane (110). The difference ΔE2 of the growth rates on the in-trench wall plane (010) side appears as approximately 3, and the sum ΔE1+ΔE2 of the differences of the growth rates appears as approximately 6. Both are found to be largely reduced from ΔE2=7 and ΔE1+ΔE2=11 shown in FIG. 15. As shown in FIG. 11, the angle of crossing of (010) composing the in-trench wall plane and the corresponding {110} plane is 45°.

As presumed from comparison between FIG. 14 and FIG. 15, in the process of changing the in-trench wall plane from (011) to (010), the growth rate within the transition plane normal line angular range θ changes from that of an increasing tendency to that of a decreasing tendency. The intermediate section thereof may, therefore, contain an angle of crossing capable of further reducing the maximum value of the growth rate, and consequently the difference ΔE2 of the growth rates (or the sum ΔE1+ΔE2), as compared with the case where the in-trench wall plane is given as (010), and at that angle, formation of the excessive growth portion may be more optimally suppressed. It is, however, anticipated that the fill-up epitaxial layer grown on the in-trench wall plane of the higher plane index may be roughened on the growth plane thereof in the process of growing, and the growth may become non-uniform against expectation. In contrast to this, the in-trench wall plane having orientation {100} is free from such anticipation, and is sufficiently good in the suppressive effect on the formation of the excessive growth portion, so that it is still none other than an embodiment especially preferable for this invention.

Next, the second aspect of the method of fabricating a silicon epitaxial wafer of this invention is characterized in comprising:
growing a fill-up epitaxial layer by placing the silicon single crystal substrate, having a trench formed therein, in a reaction vessel and heated to a predetermined growth temperature, and by supplying a source gas into the reaction vessel while keeping the state unchanged; and
under definition of a flow rate of the source gas into the reaction vessel, required for making transition temperature between a reaction rate-determining region and a supply rate-determining region with respect to silicon deposition from the source gas coinciding with the growth temperature as a critical flow rate of the source gas, the fill-up epitaxial layer is grown at the growth temperature while supplying the source gas into the reaction vessel at a flow rate larger than the critical flow rate of the source gas.

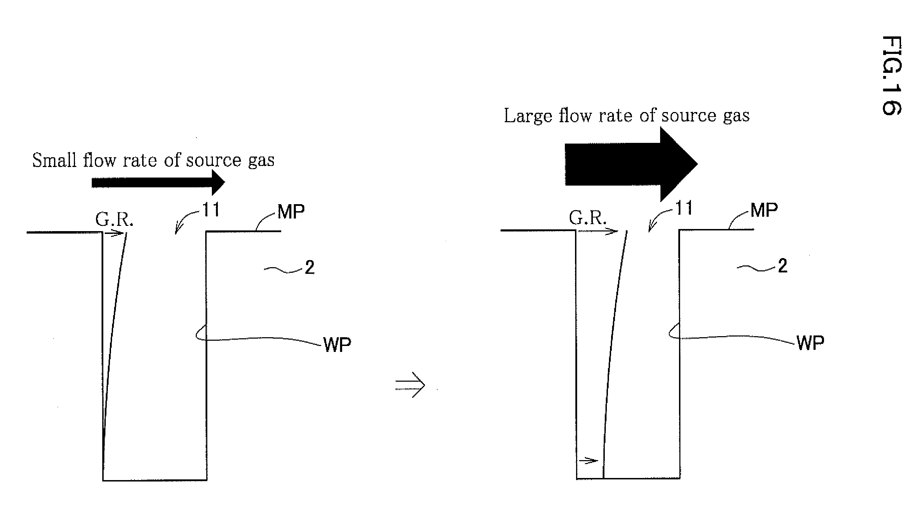

From further investigations, the present inventors found out that it was effective in view of making the growth of silicon uniform over the in-trench wall plane, and in view of making voids less likely to be produced in the fill-up epitaxial layer, to set the growth temperature at a lower temperature region causing no extremely sharp change in the growth rate relative to the concentration of the source gas, more specifically in a temperature range allowing the silicon deposition reaction to proceed in a reaction-rate-determining manner. On the other hand, the trenches are composed of a bottomed closed space, and in especially fine trenches (having a width of opening of 1 µm to 3 µm, and a depth of 20 µm to 50 µm, both ends inclusive) the space is substantially occupied by a diffusion region caused by friction with the inner wall planes, so that the source gas can be supplied into the trenches only by diffusion. When the flow rate of the supplied source gas is small as shown on the left of FIG. 16, consumption of the source gas coming by diffusion becomes relatively distinctive due to silicon deposition in the vicinity of the trench openings, and the source gas concentration becomes short around the bottom of the trenches. The growth rate (G.R.) is consequently reduced even in the reaction-rate-determining region, whereas the growth of silicon at the trench openings becomes relatively more likely to proceed, raising one reason for the narrowing of the openings.

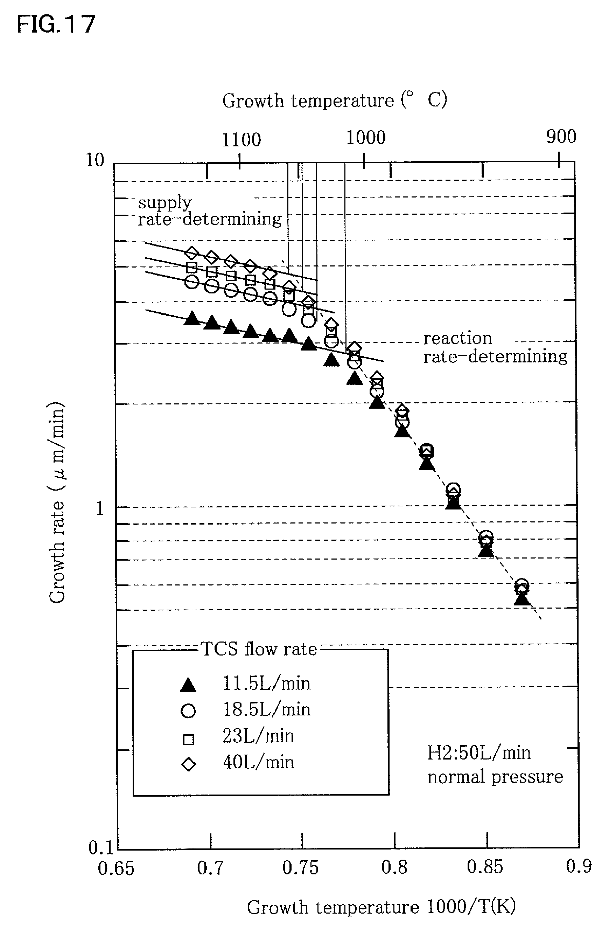

The general silicon epitaxial growth employs a carrier gas (H₂ gas, for example) at an excessive flow rate over the source gas, so that adjustments of the supply rate of the source gas correspond to adjustments of the concentration of the source gas to be supplied into the reaction vessel, and more specifically to the openings of the trenches. FIG. 17 shows the Arrhenius plot of measured results of the growth rate of silicon using trichlorosilane (TCS: SiHCl₃) as the source gas, at various growth temperatures under the individual supply rates, while fixing the supply rate of H₂ gas as the carrier gas at 50 L/min, and varying supply rate of the source gas. It was found that, at any supply rates of the source gas, the plots show different slopes (that are, apparent activation energies of the silicon growth reaction) in the reaction-rate-determining region on the lower temperature side and in the supply-rate-determining region on the higher temperature side. The transition temperature is defined as a temperature fallen on a point of intersection of regression lines, obtained by respectively subjecting the plots on the lower temperature side and on the higher temperature side on the Arrhenius plane, to a linear regression. The transition point shifts towards the higher temperature side as the supply rate of the source gas increases. From the results, it is made possible to find out the critical flow rate of the source gas as the supply rate of the source gas under which a predetermined growth temperature coincides with the transition temperature. For example, the growth temperature at around 1,000°C gives the critical flow rate of the source gas at around 11.5 L/min (this value is specific to the individual reaction vessels, and may vary depending on specifications of the vessel).

In the second aspect of the present invention, under definition of the flow rate (supply rate) of the source gas into the reaction vessel, required for making transition temperature between the reaction rate-determining region and the supply rate-determining region with respect to silicon deposition from the source gas coincide with a predetermined growth temperature, as the critical flow rate of the source gas, the source gas is supplied into the reaction vessel at a flow rate larger than the critical flow rate of the source gas. The transition temperature shifts towards the higher temperature side with an increase in the supply rate of the source gas as shown in FIG. 17, so that increases in the supply rate of the source gas over the critical flow rate of the source gas means that the growth temperature is unconditionally set in the reaction-rate-determining region. This consequently makes it possible to increase the concentration of the source gas at around the trench openings while keeping the reaction-rate-determining region, to supply a sufficient amount of source gas as deep as to the bottom of the trenches, as shown on the right of FIG. 16, even if the source gas is consumed more or less at the upper portions of the trench openings, and to thereby make a depth-wise distribution of the growth rate over the in-trench wall plane more uniform. It is therefore made possible to suppress the excessive growth of silicon at the trench openings, thus effectively preventing clogging of the openings. The second aspect of the fabrication method of this invention is more effective when combined with the first aspect of the fabrication method of this invention, and can further enhance the above-described effects.

The above-described effects become more distinctive when the supply rate of the source gas into the reaction vessel is determined so as to obtain a source gas concentration at the bottom of the trenches equal to or higher than a source gas concentration in the reaction vessel, when the source gas is supplied into the reaction vessel at the critical flow rate of the source gas. This successfully ensures a sufficient source gas concentration, required for maintaining the silicon deposition reaction based on the reaction-rate-determining process, over the entire region in the depth-wise direction of the in-trench wall plane ranging from the opening to the bottom, and to make the depth-wise distribution of the growth rate uniform to a large extent.

In this case, the source gas can be supplied while keeping the pressure in the reaction vessel at normal pressure. "Normal pressure" herein means the pressure that falls within a +/-10% range around 1×10⁵ Pa. Growth of the fill-up epitaxial layer while supplying the source gas into the reaction vessel under the normal pressure atmosphere makes it possible to raise the growth rate more than the growth under a reduced pressure atmosphere, and to improve the production efficiency. A larger growth rate tends to cause a larger influence of the growth rate distribution on the wall plane in fine trenches, and tends to raise a problem of residual voids and so forth, whereas adoption of the second aspect (also the first aspect as a consequence) of the fabrication method of this invention can effectively suppress such nonconformity, and can harmonize the improvement in the production efficiency and improvement in the yield ratio. This effect becomes particularly distinctive when trichlorosilane, having a large reaction efficiency for silicon deposition, is used.

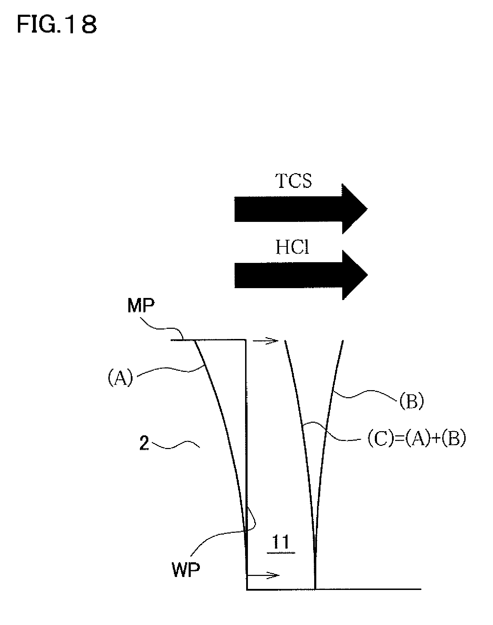

Next, for the purpose of suppressing the excessive growth of silicon at the trench openings, it is also effective to supply a growth inhibition gas inhibiting the growth of the fill-up epitaxial layer, together with the source gas into the reaction vessel. The growth inhibition gas may be a gas species suppressing decomposition reactions of the source gas, but it is more effective to adopt an etching gas for (deposited) silicon. More specifically, as shown in FIG. 18, assuming now that a gas acting as an etchant on silicon composing the in-trench wall plane is supplied alone into the trench, the depth of etching becomes larger around the trench opening, but gradually decreases towards the bottom of the trench due to consumption of the gas, as indicated by curve (A). On the other hand, as has repetitively been explained in the above when the source gas is supplied to fill the trench with silicon (fill-up epitaxial layer), the thickness of growth becomes larger at around the trench opening, but gradually decreases towards the bottom of the trench due to consumption of the gas, as indicated by curve (B). The concomitant supply of the source gas and the etching gas into the reaction vessel, therefore, makes it possible to cancel the depth-wise distribution of the etching depth indicated by curve (A) and the depth-wise distribution of the growth thickness indicated by curve (B), so as to effectively suppress the excessive growth of silicon at around the trench opening as indicated by curve (C), to thereby allow the fill-up epitaxial layer to grow uniformly on the in-trench wall plane. Use of hydrogen chloride as the etching gas is preferable in view of enhancing the above-described effects.

Japanese Laid-Open Patent Publication "Tokkai" No. 2001-196573 discloses a method of alternately repeating supply of a source gas and supply of an etching gas, but this method, based on a concept of removing, as a symptomatic treatment, the excessive growth portion by interrupting supply of the source gas and instead supplying the etching gas, is not only non-efficient, but is also unsuccessful anyhow in allowing the fill-up epitaxial layer to grown uniformly on the in-trench wall plane, because the method is on the premise that the excessive growth portion is once formed on the in-trench wall plane, and also because it is difficult to selectively remove only the excessive growth portion.

For the purpose of attaining uniform growth of the fill-up epitaxial layer on the in-trench wall plane, it is essential to suppress the production of the excessive growth portion around the trench opening as much as possible, to prevent as possible inhibition of the silicon growth around the trench bottom placed under a disadvantageous condition in terms of the silicon growth as much as possible. More specifically, it is effective to allow the etching reaction to proceed in a temperature range ensuring a supply-rate-determining mode of the etching gas. Adoption of the temperature range ensuring a supply-rate-determining mode of the etching gas makes the etching effect rapidly appear around the opening due to a high concentration of the etching gas so as to suppress the excessive silicon deposition, whereas the etching effect rapidly reduces by the time the etching gas reaches the trench bottom side, and without interfering with the growth of the layer, because concentration of the etching gas is reduced due to consumption around the opening.

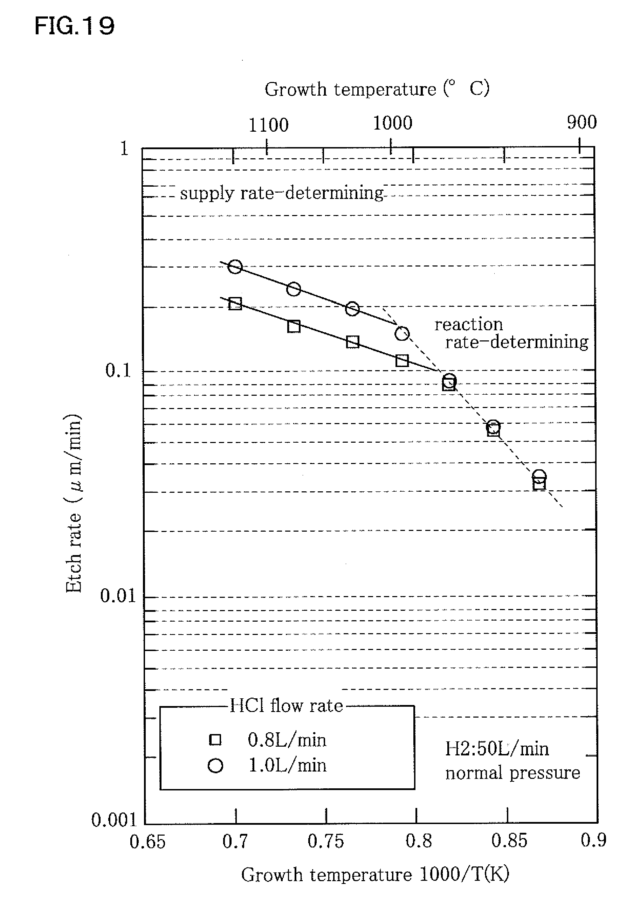

FIG. 19 shows the Arrhenius plot of results of the etchrate of the main plane of the (100) silicon single crystal substrate using hydrogen chloride as the etching gas, measured at various etching temperatures while fixing the supply rate of H₂ gas as the carrier gas at 50 L/min, and varying the supply rate of the source gas. Similarly to the case where silicon is epitaxially grown (see FIG. 17), it is known that, at any supply rates of the etching gas, the plots clearly show the reaction-rate-determining region on the lower temperature side and the supply-rate-determining region on the higher temperature side. The transition temperature is again defined as a temperature fallen on a point of intersection of a regression of lines obtained by respectively subjecting the plots on the lower temperature side and on the higher temperature side on the Arrhenius plane to linear regression. The transition point shifts towards the higher temperature side as the supply rate of the etching gas increases, so that it is made possible to find out the critical flow rate of the etching gas as the supply rate of the etching gas under which a predetermined growth temperature coincides with the transition temperature. For example, a growth temperature at around 1,000°C gives a critical flow rate of the etching gas at around 1.0 L/min (this value is specific to the individual reaction vessels, and may vary depending on the specifications of the vessel).

In this case, under definition of a flow rate of the etching gas into the reaction vessel, required for making transition temperature between the reaction rate-determining region and the supply rate-determining region with respect to silicon etching coinciding with the growth temperature as critical flow rate of the etching gas, it can be said that it is preferable to supply the etching gas into the reaction vessel at a flow rate smaller than the critical flow rate of the etching gas. More specifically, as is known from FIG. 19, reduction in the flow rate of the etching gas smaller than the critical flow rate of the etching gas means that the growth temperature is unconditionally set in the supply-rate-determining region. This consequently makes it possible to promote the selective etching at the trench opening, and to make the depth-wise distribution of silicon growth rate on the in-trench wall plane more uniform, while keeping the supply-rate-determining region. It is to be noted that an excessively small flow rate of the etching gas results in only an insufficient etching effect, so that it is preferable to determine the lower limit of the flow rate of the etching gas so far as not to leave the excessive growth portion at the trench opening.

### Brief Description of the Drawings

FIG. 1 is a sectional view schematically showing an exemplary silicon epitaxial wafer of this invention;
FIG. 2 is a sectional view schematically showing an exemplary silicon epitaxial wafer of this invention;
FIG. 3 is a schematic sectional view showing a trench in enlargement;
FIG. 4 is the first process drawing explaining an exemplary method of fabricating the wafer shown in FIG. 1;
FIG. 5 is the second process drawing of the same;
FIG. 6 is the third process drawing of the same;
FIG. 7 is the schematic sectional view showing an exemplary vapor phase growth apparatus used in the process shown in FIG. 5;
FIG. 8 is a drawing explaining a problem with the conventional method of fabrication;
FIG. 9 is a graph showing growth rate in epitaxial growth of silicon on various crystal planes, expressed by a function of an angle away from plane (111);
FIG. 10 is a perspective view schematically showing a process of formation of an excessive growth portion in the vicinity of the transition plane region composing the opening edge of the trench;
FIG. 11 is a drawing explaining interrelation of various plane orientation in a silicon single crystal substrate having (100) main plane;
FIG. 12 is a drawing explaining transition plane normal line angular range when the substrate main plane is given as (100) and the in-trench wall plane is given as (010);
FIG. 13 is a drawing explaining transition plane normal line angular range under when the substrate main plane is given as (100) and the in-trench wall plane is given as (011);
FIG. 14 is a graph showing changes in the growth rate of the epitaxial layer within the transition plane normal line angular range θ over which a normal line on the surface transits from [100] through [110] to [010];
FIG. 15 is a graph showing changes in the growth rate of the epitaxial layer within the transition plane normal line angular range θ over which a normal line on the surface transits from [100] through [111] to [011];
FIG. 16 is a drawing explaining the effect of increasing a source gas beyond the critical flow rate of the source gas in the reaction rate-determining region;
FIG. 17 is a graph obtained by the Arrhenius plot of measured results of growth rate of silicon at various growth temperatures under the individual flow rate conditions, while the varying setting of the rate of supply of the source gas in a variable manner;
FIG. 18 is a drawing explaining the effect of supplying an etching gas together with the source gas;
FIG. 19 is a graph obtained by the Arrhenius plot of measured results of etchrate of silicon at various temperatures under the individual flow rate conditions, while varying the settings of the rate of supply of the etching gas;
FIG. 20 is a drawing explaining the concept of transition plane normal line angular range, and transition plane region;
FIG. 21 is a TEM observation image of a fill-up epitaxial layer having a planar defect portion formed therein; and

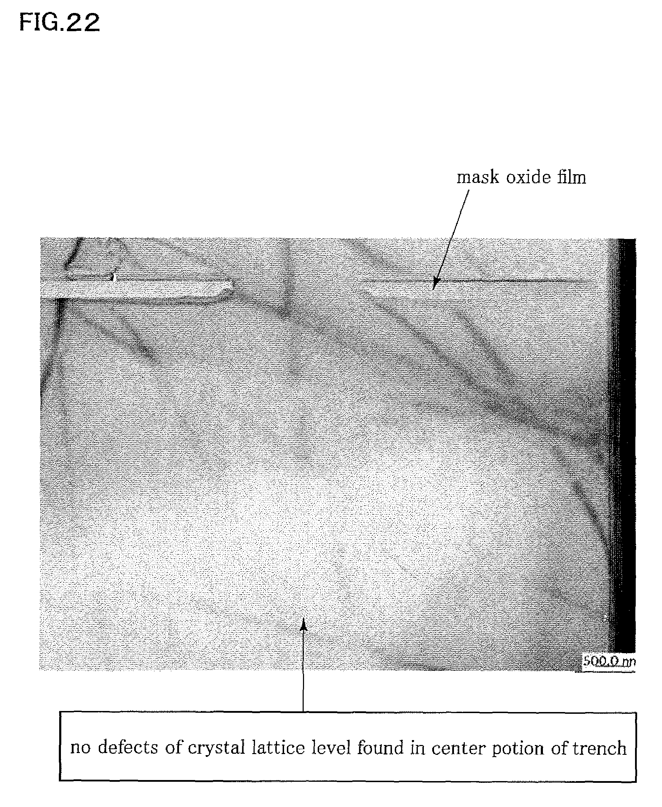

FIG. 22 is a TEM observation image of a fill-up epitaxial layer from which planar defect portion was excluded.

### Explanation of the Marks

1 silicon epitaxial wafer
2 silicon single crystal substrate
3 fill-up epitaxial layer
11 trench
122 reaction vessel

### Best Modes for Carrying out the Invention

The following paragraphs will describe the best modes for carrying out the invention, referring to the attached drawings.

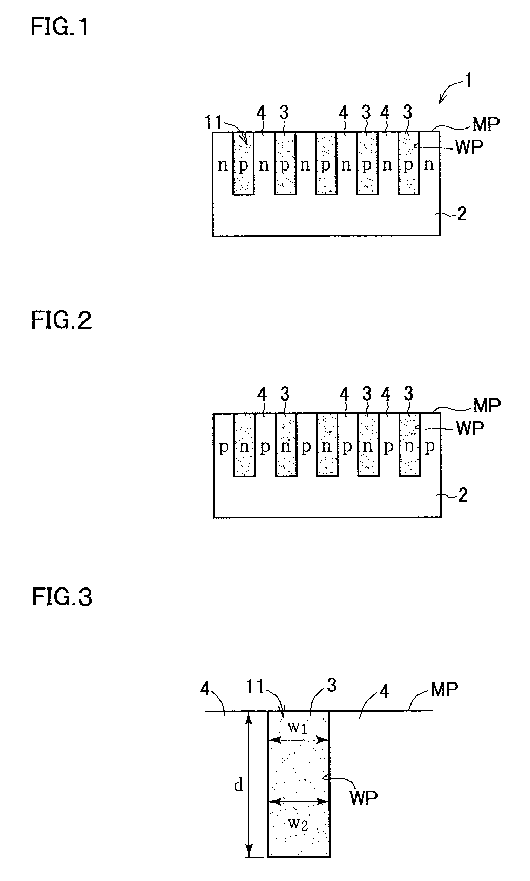

FIG. 1 is a schematic sectional view showing an exemplary silicon epitaxial wafer of this invention. A silicon epitaxial wafer 1 has a structure in which a plurality of trenches 11 are formed at regular intervals, so as to align the longitudinal direction thereof with a predetermined direction, on the substrate main surface MP of an n-type silicon single crystal substrate 2 doped with P, As or Sb, and each of the inner space of the trenches 11 is filled with a fill-up epitaxial layer 3 composed of p-type silicon single crystal doped with B. Between every adjacent fill-up epitaxial layers 3, there are formed n-type layer regions 4 derived from the substrate 2. It is also allowable, as shown in FIG. 2, to use a p-type silicon single crystal substrate 2, and to form the fill-up epitaxial layer 3 as the n-type layer region. As shown in FIG. 3, depth d of trench 11 is 20 µm to 50 µm, both ends inclusive, and width w1 of the trench 11 (fill-up epitaxial layer 3) is 1 µm to 3 µm, both ends inclusive. Also the width of the n-type layer region 4 (p-type layer region in FIG. 2) between every adjacent fill-up epitaxial layers 3, 3 is 1 µm to 3 µm, both ends inclusive.

In this embodiment, the plane index of the substrate main plane MP is (100), and the plane index of the wall plane WP of the trench 11 is (010). The width w1 of the opening portion of the trench 11 (fill-up epitaxial layer 3) is almost equal to width w2 at the bottom portion, where w1 may be set wider than w2 (in this case, the plane index of the wall plane WP will be higher than (010)).

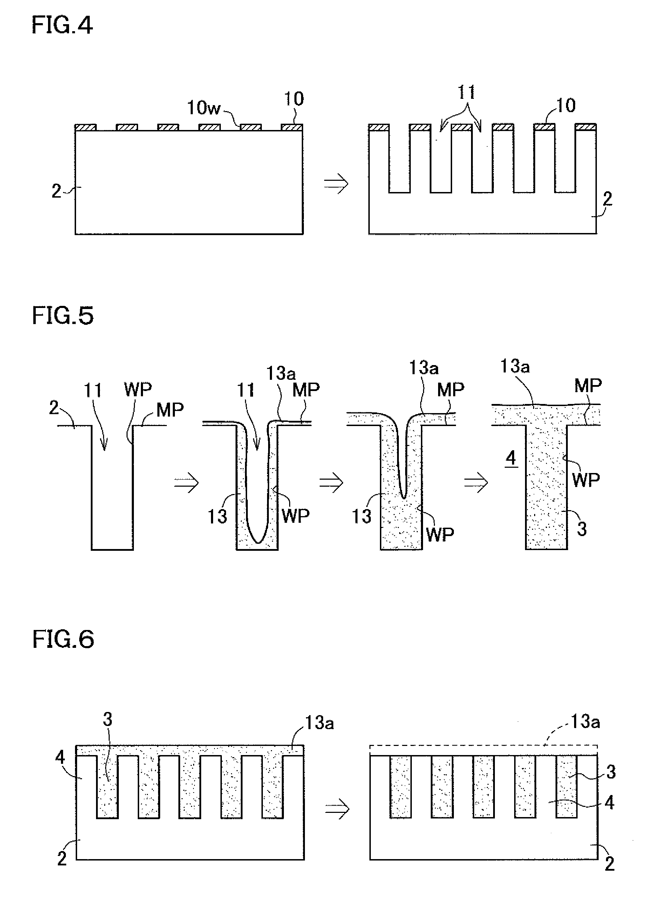

The following paragraphs will describe an exemplary method of fabricating the silicon epitaxial wafer 1. First, as shown in FIG. 4, on the substrate main plane of the n-type silicon single crystal substrate 2, a silicon oxide film 10 is formed as a thermal oxide film, as having windows 10w for forming the trenches formed by a publicly-known photolithographic technique. The substrate 2 is then etched, by a dry etching process such as reactive ion etching (wet etching may be allowable, but dry etching is more preferable in view of increasing steepness of the wall plane of the trenches) from the surface exposed in the windows 10w in the depth-wise direction, to thereby form the trenches 11. The silicon oxide film 10 is then removed by wet etching. This sort of method for forming trenches is publicly known typically in Japanese Laid-Open Patent Publication "Tokkai" No. 2002-141407, and will not be detailed herein.

Next, as shown in FIG. 5, a p-type silicon epitaxial layer 13 is grown in vapor phase on the substrate main plane MP side. In this process, the silicon single crystal substrate 2 is placed in a vapor phase growth apparatus, annealed at a predetermined temperature (at 1,130°C in a hydrogen atmosphere, for example), and thereon the fill-up epitaxial layer 3 is grown in vapor phase.

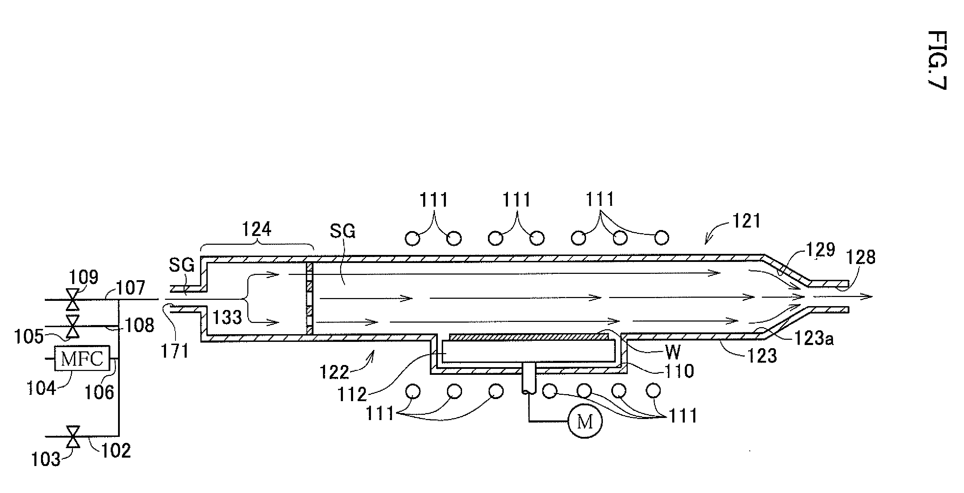

FIG. 7 is a side-elevational sectional view of a vapor phase growth apparatus 121. The vapor phase growth apparatus 121 has a flat-box-type reaction vessel 122, wherein through a gas introducing port 171 formed on one end thereof, a source gas SG is supplied via a flow control section 124 into the inner space of the main vessel 123 in a horizontal-and-unidirectional manner. In the main vessel 123, only a single wafer W is placed in a near horizontal manner on susceptor 112 placed in a susceptor housing recess 110. The reaction vessel 122 has, on the end portion thereof opposite to that having the source gas introducing duct 171 formed thereon, a gas discharging port 128 as being placed next to a venturi-formed drawn section 129. The source gas SG introduced therethrough passes over the surface of the wafer W, and is then discharged through the gas discharging port 128. Trichlorosilane gas is typically used as the source gas SG. The trichlorosilane gas is prepared as a mixed gas having a constant concentration obtained by bubbling hydrogen gas into liquid trichlorosilane (SiHCl₃), and is then introduced to pipe 107 while being regulated in the flow rate thereof by valve 109. On the other hand, hydrogen gas for dilution use is introduced through valve 105 into pipe 108, and both are further mixed to finally adjust the trichlorosilane concentration, and then are allowed to flow into reaction vessel 122 through source gas introducing port 171. On the other hand, a dopant gas (diborane (B₂H₆) is typically used for addition of a p-type impurity intended herein) is preliminarily diluted with hydrogen gas or the like, and supplied through pipe 106 into reaction vessel 122 while being regulated in the flow rate thereof by mass flow controller (MFC) 104. The wafer W is rotated together with susceptor 112 by a motor M, and on which an epitaxial layer is grown under supply of the source gas SB, while being heated by infrared heating lamps 111. Pressure in the reaction vessel 122 may be set at normal pressure, but is preferably set slightly higher than the atmospheric pressure in order to avoid sucking of the outer air.

The growth temperature is adjusted within the range from 850°C to 1,100°C, both ends inclusive. As previously explained referring to FIG. 17, a critical flow rate of the source gas, required for making transition temperature between the reaction rate-determining region and the supply rate-determining region with respect to silicon deposition from tichlorosilane gas coinciding with the growth temperature, is preliminarily found out, and trichlorosilane is supplied at a flow rate larger than the critical flow rate of the source gas into reaction vessel 122. More specifically, the supply rate of trichlorosilane into reaction vessel 122 is determined so as to obtain a trichlorosilane concentration at the bottom of the trenches 11 equal to or higher than a trichlorosilane concentration in the reaction vessel 122 when the source gas is supplied into the reaction vessel 122 at the critical flow rate of the source gas. In this embodiment, with the setting of the growth temperature at about 1,000°C, a condition ranging from 18.5 L/min to 40 L/min shown in FIG. 17 is adopted.

Together with trichlorosilane, hydrogen chloride as the etching gas is supplied through pipe 102 into reaction vessel 122 while being regulated in the flow rate thereof by valve 103. As previously explained referring to FIG. 19, under definition of a flow rate of the hydrogen chloride gas into reaction vessel 122, required for making transition temperature between the reaction rate-determining region and the supply rate-determining region with respect to silicon etching coinciding with the growth temperature as a critical flow rate of the etching gas, the hydrogen chloride gas is supplied into reaction vessel 122 at a flow rate smaller than the critical flow rate of the etching gas. In this embodiment, under setting of the growth temperature at about 1,000°C, a condition ranging from 1.0 L/min to 0.8 L/min shown in FIG. 19 is adopted.

Referring now back to FIG. 5, with the progress of the growth of the epitaxial layer 13 as described in the above, the inner space of the trenches 11 is filled with a silicon epitaxial layer, which finally forms the fill-up epitaxial layer 3. The epitaxial layer 13 has an unnecessary grown layer 13a deposited in the region of the substrate main plane MP outside the trenches, which is removed by polishing as shown in FIG. 6, and thereby the epitaxial wafer 1 shown in FIG. 1 is completed.

Adoption of the above described process steps in this case makes it possible to effectively prevent nonconformities such that voids 16a, 16b as shown in FIG. 8 remain in the fill-up epitaxial layer 3. The three reasons for this can be summarized as follows.
(Essential Point 1) Because the substrate main plane MP is given as (100) and the in-trench wall plane WP as (010), the transition plane normal line angular range formed between the normal line vector α and the normal line vector β, or in the opening edge portion of the trenches 11, does not contain plane {111}, but contains (110) giving a maximum growth rate as shown in FIG. 14. The growth rate of silicon therefore changes in the direction of decreasing as the point of observation shifts towards either the in-trench wall plane WP side or towards the substrate main plane MP side from the opening edge portion, and this successfully suppresses formation of the excessive growth portion causative of narrowing the opening of the trenches 11.

(Essential Point 2) The growth temperature is set in a low temperature range in which the growth rate does not vary in an extremely sensitive manner to trichlorosilane concentration, and more specifically, the growth temperature is set at a temperature range allowing the silicon deposition reaction to proceed based on the reaction-determining process. In addition, the flow rate of trichlorosilane is set considerably larger than the critical flow rate of source gas, so as to supply a sufficient concentration of trichlorosilane to the bottom of the trenches, even if the source gas is consumed to a certain extent at the upper portion of the trench openings. This ensures a sufficient trichlorosilane concentration required for maintaining the silicon deposition reaction based on the reaction-rate-determining process, over the entire portion of the in-trench wall plane WP in the depth-wise direction ranging from the opening to the bottom, so that the growth rate on the bottom side of the trenches 11 can catch up with the growth rate on the opening side, and thereby a depth-wise distribution of the growth rate can be made uniform.

(Essential Point 3) Hydrogen chloride as the etching gas is supplied simultaneously with trichlorosilane, and this suppresses generation of the excessive growth portion in the vicinity of the opening of the trenches 11. In addition, the etching reaction always proceeds in the supply rate-determining region, because hydrogen chloride is supplied at a flow rate smaller than the critical flow rate of the etching gas corresponding to the growth temperature. This allows the etching effect to swiftly appear in the vicinity of the opening of trenches 11 by virtue of a large concentration of hydrogen chloride, and suppresses the excessive silicon deposition, whereas the concentration of hydrogen chloride decreases when the gas reaches as far as the trench bottom after being consumed at around the opening ends, thereby the etching effect sharply reduces and never interferes the layer growth. The growth rate on the bottom side of trenches 11 can therefore catch up with the growth rate on the opening side, and thereby a depth-wise distribution of the growth rate can be made uniform.

Discussing now the situation of the void formation in the fill-up epitaxial layer 3 as shown in FIG. 8, it is understood that the excessive growth portion is more likely to combine in the vicinity of the opening ends of trenches 11, and this makes the first void 16a more likely to occur just thereunder. On the other hand, portions around the bottom of trenches 11 (that is, assuming the depth of the trenches 11 as d, a position more closer to the bottom than position d/2) are more likely to cause a shortage in the amount of source gas supplied, and this makes the second void 16b more likely to occur in a form of, so as to say, left alone. Therefore, it may also be understood that Essential Points 1 and 3 have a contribution mainly in view of suppressing formation of the excessive growth portion, and Essential Point 2 has a contribution mainly in view of promoting the growth of the fill-up epitaxial layer 3 on the trench bottom side. The first void 16a might be removed to a certain extent in the process of polishing the unnecessary grown layer 13a on the substrate main plane MP, if the depth of polishing is set slightly deeper, whereas the second void 16b can never be repaired once it remains, so that it is understood as extremely important to consider Essential Point 2 in the process. This makes it possible to realize the epitaxial wafer having the fill-up epitaxial layer 3 having no void 16b remained therein at a position closer to the bottom side than position d/2 (more preferably d/5).

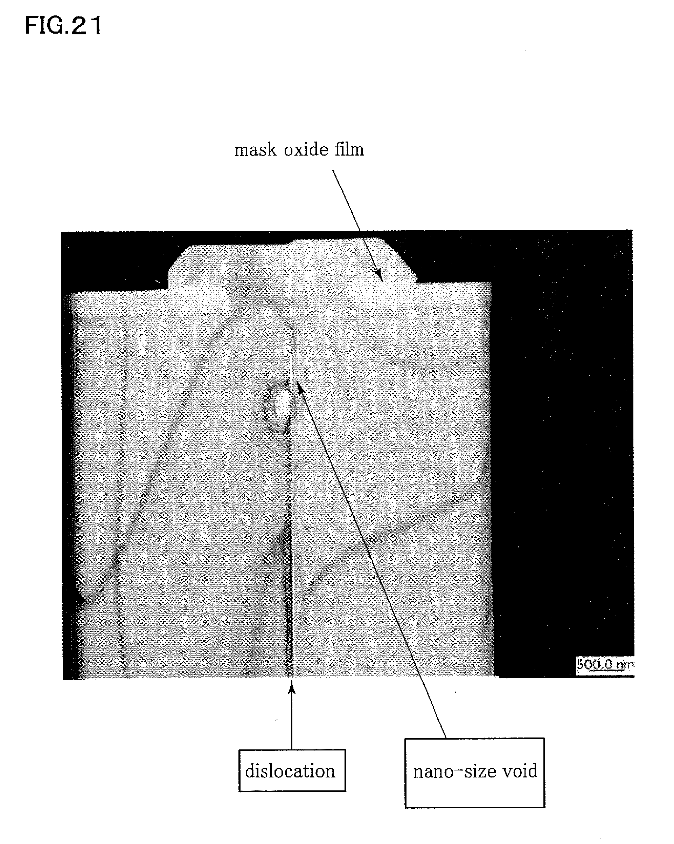

If the growth on the in-trench wall plane proceeds more excessively than the growth on the trench bottom, the in-trench wall planes combine with each other before the bottom elevates, and this makes the planar defect portion, as a trace of combination of both wall planes, more likely to be formed in the fill-up epitaxial layer, in the depth-wise direction of the trenches. When the combination of the wall planes proceeds partially in a certain region in the depth-wise direction of the trenches, the peripheral regions left uncombined will be remained as voids. Even if such voids do not seem to remain in a macroscopic view, it is very often that a large number of dislocations and nano-size microvoids remain at the planar defect portion, as shown in TEM observation result in FIG. 21. As a consequence, a large risk of failure in the device fabrication process still remains for example in that causing contamination due to heavy metals or any other impurities coming into the planar defect portion, increase in leakage current due to formation of an interface state, and decrease in the breakdown voltage. In contrast, the thorough promotion of the growth at the trench bottom as described in the above allows the elevation of the trench bottom to proceed in a sufficiently rapid manner before the in-trench wall planes have combined with each other, and this effectively suppresses the formation of the above-described planar defect portion, as shown in the TEM observation result in FIG. 21. The fill-up epitaxial layer obtained in this case will have no such planar defect portion formed therein, and even if it should be formed, can readily be removed typically by polishing, because the level of the defect bottom is effectively prevented from being positioned more closer to the bottom of the trench beyond position d/5 from the opening edge.

## Claims

1. A method of fabricating a silicon epitaxial wafer having a trench formed on the main plane of a silicon single crystal substrate, the inner space of the trench being filled with a fill-up epitaxial layer composed of silicon single crystal, comprising:
under definition of an angular range allowing overlapping, at a minimum angle of rotation, of a normal line vector α on the main plane of the substrate and a normal line vector β on the inner wall plane in the longitudinal direction of the trench as a transition plane normal line angular range, and under assumption of a region composing the opening edge in the longitudinal direction of the trench as a transition plane region over which a normal line vector continuously changes within the transition plane normal line angular range, determining the Miller index (h₁k₁l₁) of the main plane of the substrate and the Miller index (h₂k₂l₂) of the inner wall plane in the longitudinal direction of the trench, so as to make a normal line vector on plane {111} fall outside the transition plane normal line angular range; and
obtaining a silicon single crystal substrate having the main plane expressed by the Miller index (h₁k₁l₁), forming a trench having the inner wall plane in the longitudinal direction expressed by the Miller index (h₂k₂l₂) on the main plane of the substrate, and allowing the fill-up epitaxial layer to grow inside the trench.

2. The method of fabricating a silicon epitaxial wafer as claimed in Claim 1, wherein the Miller index (h₁k₁l₁) of the main plane of the substrate and the Miller index (h₂k₂l₂) of the inner wall plane in the longitudinal direction of the trench are determined so as to maximize a growth rate distribution of silicon in the transition plane region at an intermediate angular position between the main plane of the substrate and the inner wall plane in the longitudinal direction of the trench.

3. The method of fabricating a silicon epitaxial wafer as claimed in Claim 1 or 2, wherein the fill-up epitaxial layer is formed by placing the silicon single crystal substrate, having a trench formed therein, in a reaction vessel and heated to a predetermined growth temperature, and by supplying a source gas into the reaction vessel while keeping the state unchanged; and
under definition of a flow rate of the source gas into the reaction vessel, required for making transition temperature between a reaction rate-determining region and a supply rate-determining region with respect to silicon deposition from the source gas coinciding with the growth temperature as a critical flow rate of the source gas, the fill-up epitaxial layer is grown at the growth temperature while supplying the source gas into the reaction vessel at a flow rate larger than the critical flow rate of the source gas.

4. A method of fabricating a silicon epitaxial wafer comprising:
growing the fill-up epitaxial layer by placing the silicon single crystal substrate, having a trench formed therein, in a reaction vessel and heated to a predetermined growth temperature, and by supplying a source gas into the reaction vessel while keeping the state unchanged; and
under definition of a flow rate of the source gas into the reaction vessel, required for making transition temperature between a reaction rate-determining region and a supply rate-determining region with respect to silicon deposition from the source gas coinciding with the growth temperature as a critical flow rate of the source gas, the fill-up epitaxial layer is grown at the growth temperature while supplying the source gas into the reaction vessel at a flow rate larger than the critical flow rate of the source gas.

5. The method of fabricating a silicon epitaxial wafer as claimed in Claim 3 or Claim 4, wherein supply rate of the source gas into the reaction vessel is determined so as to obtain a source gas concentration at the bottom of the trench equal to or higher than the source gas concentration in the reaction vessel attainable when the source gas is supplied into the reaction vessel at the critical flow rate of the source gas.

6. The method of fabricating a silicon epitaxial wafer as claimed in any one of Claim 3 to Claim 5, wherein the source gas is supplied while keeping pressure in the reaction vessel at normal pressure.

7. The method of fabricating a silicon epitaxial wafer as claimed in any one of Claim 3 to Claim 6, wherein the source gas is trichlorosilane.

8. The method of fabricating a silicon epitaxial wafer as claimed in any one of Claim 1 to Claim 7, wherein a growth inhibition gas inhibiting the growth of the fill-up epitaxial layer is supplied at the growth temperature, into the reaction vessel together with the source gas.

9. The method of fabricating a silicon epitaxial wafer as claimed in Claim 8, wherein the growth inhibition gas is an etching gas effective to silicon.

10. The method of fabricating a silicon epitaxial wafer as claimed in Claim 9, wherein the etching gas is hydrogen chloride.

11. The method of fabricating a silicon epitaxial wafer as claimed in Claim 9 or Claim 10, wherein
under definition of a flow rate of the etching gas into the reaction vessel, required for making the transition temperature between a reaction rate-determining region and a supply rate-determining region with respect to silicon etching coinciding with the growth temperature as critical flow rate of the etching gas, the etching gas is supplied into the reaction vessel at a flow rate smaller than the critical flow rate of the etching gas.

12. A silicon epitaxial wafer having a trench formed on the main plane of a silicon single crystal substrate, the inner space of the trench being filled with a fill-up epitaxial layer composed of silicon single crystal, comprising:
under definition of an angular range allowing overlapping, at a minimum angle of rotation, of a normal line vector α on the main plane of the substrate and a normal line vector β on the inner wall plane in the longitudinal direction of the trench as a transition plane normal line angular range, and under assumption of a region composing the opening edge in the longitudinal direction of the trench as a transition plane region over which a normal line vector continuously changes within the transition plane normal line angular range, having the Miller index (h₁k₁l₁) of the main plane of the substrate and the Miller index (h₂k₂l₂) of the inner wall plane in the longitudinal direction of the trench determined so as to make a normal line vector on plane {111} fall outside the transition plane normal line angular range.

13. A silicon epitaxial wafer as claimed in Claim 12, wherein the Miller index (h₁k₁l₁) of the main plane of the substrate and the Miller index (h₂k₂l₂) of the inner wall plane in the longitudinal direction of the trench are determined so as to maximize a growth rate distribution of silicon in the transition plane region at an intermediate angular position between the main plane of the substrate and the inner wall plane in the longitudinal direction of the trench.
